# EUROPÄISCHE PATENTANMELDUNG

(11) **EP 1 063 772 A1**
(43) Veröffentlichungstag der Anmeldung: **27.12.2000**
(21) Anmeldenummer: 00107490.5
(22) Anmeldetag: 06.04.2000
(51) Int. Cl.: H03K 17/06

(54) **Treiberschaltung zum Ansteuern einer Halbbrücke**

(30) Priorität: 21.04.1999 DE 19918040
(71) Anmelder: Infineon Technologies AG, 81541 München (DE)
(72) Erfinder: Sander, Rainald, 81543 München (DE); Christoph, Axel, 8010 Graz (AT)
(74) Vertreter: Zedlitz, Peter, Dipl.-Inf.

(57) **Zusammenfassung**

Es wird eine Treiberschaltung zum Ansteuern einer Halbbrücke vorgeschlagen, die aus einem High-Side-(T1,T2,UH1) und einem Low-Side-(T3,T4,UL1)Halbleiterschalter besteht, die seriell zwischen einem ersten und einem zweiten Versorgungspotentialanschluß (1,2) verschalten sind. Jedem der beiden Halbleiterschalter ist eine Ansteuerung zugeordnet, die jeweils nach Maßgabe eines Ansteuersignals (ASL1,ASL3,ASS1,ASS3) in den jeweiligen Halbleiterschalter sperrend oder leitend schaltet. Eine Last (R_{L}) ist zwischen dem High-Side-(T1,T2,UH1) und dem Low-Side-(T3,T4,UL1)Halbleiterschalter anschließbar. Für einen Sperrzustand eines Halbleiterschalters wird dessen Steueranschluß (G1,G3,GH1,GL1) in etwa mit dem Potential des zweiten Versorgungspotentialanschlusses (2) beaufschlagt, um eine negative Vorspannung des Steueranschlusses gegenüber dem Sourceanschluß (51,53) zu erzielen.

## Beschreibung

Die Erfindung betrifft eine Treiberschaltung zum Ansteuern einer Halbbrücke bestehend aus einem High-Side- und einem Low-Side-Halbleiterschalter, die seriell zwischen einem ersten und einem zweiten Versorgungspotentialanschluß verschalten sind, wobei jedem Halbleiterschalter eine Ansteuerung zugeordnet ist, die nach Maßgabe eines Ansteuersignals den jeweiligen Halbleiterschalter leitend oder sperrend schaltet und wobei eine Last zwischen dem High-Side- und dem Low-Side-Halbleiterschalter anschließbar ist.

Als High-Side-Halbleiterschalter werden Halbleiterschalter bezeichnet, die mit ihren Laststromanschlüssen zwischen einem ersten Versorgungspotentialanschluß, der üblicherweise die positive Betriebsspannung aufweist, und einem Lastausgang verschalten sind. Low-Side-Halbleiterschalter sind hingegen mit ihren Laststromanschlüssen zwischen dem Lastausgang und einem zweiten Versorgungspotentialanschluß verschalten. Der zweite Versorgungspotentialanschluß weist dann in der Regel ein Bezugspotential, z. B. das Massepotential auf. Jeder der beiden Halbleiterschalter benötigt eine Ansteuerung, die den jeweiligen Halbleiterschalter leitend oder sperrend schaltet. Bei einer Verschaltung der beiden Halbleiterschalter zu einer Halbbrücke darf zu einem bestimmten Zeitpunkt nur jeweils einer der beiden Halbleiterschalter leitend geschalten sein. Die dem High-side- bzw. Low-Side-Halbleiterschalter zugeordneten Ansteuerungen sind deshalb in der Regel miteinander gekoppelt, um dieser Bedingung Rechnung zu tragen. Als Halbleiterschalter können z. B. MOSFETs verwendet werden.

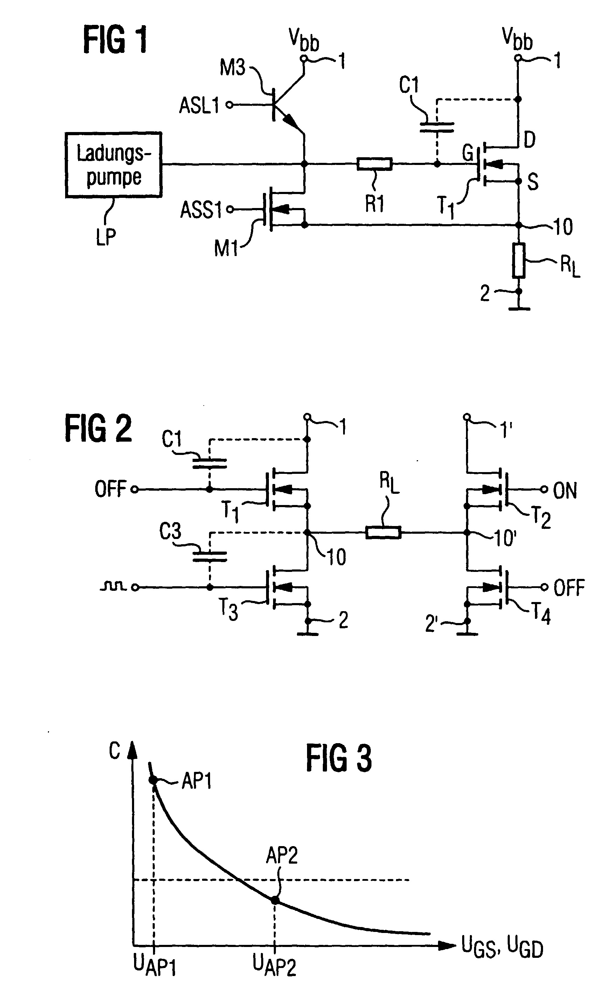

In Figur 1 ist eine Ansteuerung für einen High-Side-Halbleiterschalter dargestellt, anhand der die prinzipielle Funktionsweise erklärt werden soll. Zwischen einem ersten Versorgungspotentialanschluß 1, an dem eine positive Betriebsspannung V_{bb} anliegt, und einen Lastausgang 10 ist ein MOSFET T1 verschalten. Der Drainanschluß des MOSFETs T1 steht dabei mit dem ersten Versorgungspotentialanschluß 1 in Verbindung, während der MOSFET sourceseitig mit dem Lastausgang 10 verbunden ist. Zur Laststrecke des MOSFETs T1 ist seriell eine Last RL verschalten, die einerseits mit dem Lastausgang 10 und andererseits mit einem zweiten Versorgungspotentialanschluß 2 in Verbindung steht. An dem Versorgungspotentialanschluß 2 liegt ein Bezugspotential, z. B. das Massepotential an. Es ist weiterhin eine Ladungspumpe LP vorgesehen, die über einen Widerstand R1 mit dem Gate des MOSFETs T1 verbunden ist.

Ein Bipolartransistor M3 ist mit seinem Kollektor mit dem ersten Versorgungspotentialanschluß 1 und mit seinem Emitter mit dem Verbindungspunkt zwischen der Ladungspumpe LP und dem Widerstand R1 verbunden. Wird an seine Basis über einen Steuereingang ASL1 ein Spannungssignal angelegt, so wird der Bipolartransistor M3 leitend und er kann im Zusammenwirken mit der Ladungspumpe LP das Gate des MOSFETs T1 aufladen und diesen leitend steuern.

Um den MOSFET T1 sicher sperren zu können, ist ein weiterer MOSFET M1 vorgesehen, der von dem entgegengesetzten Leitungstyp wie der MOSFET T1 ist. Der MOSFET M1 ist mit seinem Drainanschluß über den Widerstand R1 mit dem Gate des MOSFETs T1 verbunden, während der Sourceanschluß des MOSFETs M1 mit dem Sourceanschluß des MOSFETs T1 in Verbindung steht. An einem Steuereingang ASS1, der mit dem Gate des MOSFETs M1 verbunden ist, liegt ein zu dem Steuereingang ASL1 komplementäres Ansteuersignal an.

Zum Sperren des MOSFETs T1 ist es folglich notwendig, den Bipolartransistor M3 über ein entsprechendes Ansteuersignal zu sperren, während dem MOSFET M1 über den Steuereingang ASS1 leitend geschalten wird. Hierdurch wird das Gate des MOSFETs T1 in etwa auf das Potential des Sourceanschlusses des MOSFETs T1 gebracht, womit ein Sperren des MOSFETs M1 erzielt wird. Ein detailliertes Ausführungsbeispiel einer Ansteuerung für einen MOSFET mit sourceseitiger Last ist beispielsweise in der EP 0 572 706 A1 beschrieben.

Die Ansteuerung für einen Low-Side-Halbleiterschalter ist prinzipiell identisch aufgebaut. Es kann jedoch auf die Ladungspumpe LP verzichtet werden, da am Gate des entsprechenden Leistungsschalters keine Spannung benötigt wird, die über der Betriebsspannung V_{bb} liegt.

Häufig werden in der Praxis mehrere Halbbrücken miteinander verschalten. So ist beispielsweise in Figur 2 eine aus dem Stand der Technik bekannte H-Brückenschaltung aus zwei Halbbrücken dargestellt. Eine derartige Vollbrücke wird beispielsweise zur Ansteuerung von Motorlasten verwendet. Die H-Brückenschaltung erlaubt einen Richtungswechsel des Laststromes.

Zwischen dem ersten Versorgungspotentialanschluß 1 und dem zweiten Versorgungspotentialanschluß 2 ist die Reihenschaltung aus einem High-Side-Halbleiterschalter T1 bzw. T2 sowie dem Low-Side-Halbleiterschalter T3 bzw. T4 verschalten. Zwischen dem Lastausgang 10 bzw. 10' ist eine Last RL verschalten, die beispielsweise als Motor ausgeführt sein kann. Die Halbleiterschalter T1 und T4 sind im vorliegenden Beispiel durch die (nicht gezeigten) Ansteuerungen sperrend geschalten. Der Laststrom fließt folglich vom ersten Versorgungspotentialanschluß 1' über den High-Side-Halbleiterschalter T2, den Lastausgang 10', die Last RL, den Lastausgang 10, sowie den Low-Side-Halbleiterschalter T3. In dem speziellen Ausführungsbeispiel der Figur 2 wird der Low-Side-Halbleiterschalter T3 über ein hochfrequentes Pulsweitenmodulationssignal angesteuert, während der High-Side-Halbleiterschalter T2 permanent leitend geschalten ist. Hierdurch ist das Regulieren des Laststromes möglich. Bedingt durch das Ein- und Ausschalten des Low-Side-Halbleiterschalters T3 wechselt das Potential des Lastausgangs 10 zwischen der Versorgungsspannung V_{bb} und dem Massepotential mit hoher Frequenz.

Bedingt durch den technologischen Aufbau eines MOSFETs besteht zwischen dem Gate und dem Drain bzw. dem Gate und dem Source eine kapazitive Kopplung. Die zwischen dem Gate und dem Drain bestehende Kapazität wird als 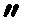 Miller-Kapazität" bezeichnet. Die Miller-Kapazität des Halbleiterschalters T1 ist mit C1 gestrichelt eingezeichnet.

Die Miller-Kapazität C1 zwischen dem Gate und dem Drain des High-Side-Halbleiterschalters verhindert jedoch, daß die Gatespannung der Sourcespannung am Lastausgang 10 entsprechend den schnellen Potentialwechseln durch die Pulsweitenmodulation des Low-Side-Halbleiterschalters T3 folgt. Wird beispielsweise der Low-Side-Halbleiterschalter T3 leitend geschalten, so wechselt das Potential am Lastausgang 10 von der Betriebsspannung V_{bb} zum Massepotential. Bedingt durch die Miller-Kapazität C1 bildet sich am High-Side-Schalter T1 eine Gate-Source-Spannung aus, welche den Halbleiterschalter T1 kurzzeitig einschalten kann und somit einen unerwünschten Querstrom produziert. Dieser Querstrom führt zum einen zu einer unbrauchbaren Temperaturerhöhung im Halbleiterschalter T1, zum anderen können unerwünschte Funktionsstörungen in der gesamten Schaltungsanordnung auftreten.

Häufig werden drei Halbbrücken zu einer Drehstrom-Brückenschaltung verschaltet, die dann beispielsweise einen bürstenlosen Drehstrommotor antreiben können. Da die Halbleiterschalter einer Drehstrombrücke auch sehr hochfrequent über eine Pulsbreitensteuerung angesteuert werden können, besteht auch hier die Problematik störender Querströme.

Eine Treiberschaltung zum Ansteuern einer Halbbrücke ist beispielsweise aus der DE 40 32 014 A1 bekannt. In der dort beschriebenen Schaltungsanordnung wird der Zustand (Halbleiterschalter leitend oder nichtleitend) der beiden Halbleiterschalter detektiert und durch eine entsprechende Ansteuerung sichergestellt, daß einer beiden Halbleiterschalter nur dann leitend geschalten werden kann, wenn der andere bereits im nicht leitenden Zustand ist. Hierzu werden Totzeiten zwischen den Schaltvorgängen der einzelnen Halbleiterschalter vorgesehen. Die dort beschriebene Vorgehensweise weist jedoch den Nachteil auf, daß die Haibleiterschalter nicht mit beliebig hohen Frequenzen angesteuert werden können. Weiterhin ist die Problematik der Miller-Kapazitäten nicht berücksichtigt. Auch bei der dortigen Treiberschaltung kann es vorkommen, daß der an sich ausgeschaltene Halbleiterschalter durch die Wirkung der Miller-Kapazität eingeschaltet werden kann, wenn der andere Halbleiterschalter gerade in den leitenden Zustand gesteuert wird.

Die Aufgabe der vorliegenden Erfindung besteht deshalb darin, eine Treiberschaltung zum Ansteuern einer Halbbrücke vorzusehen, die ein unbeabsichtigtes leitend Schalten eines an sich sperrenden Halbleiterschalters verhindert.

Diese Aufgabe wird mit den Merkmalen des Patentanspruchs 1 gelöst.

Erfindungsgemäß ist bei der gattungsgemäßen Treiberschaltung vorgesehen, die einem Halbleiterschalter zugeordnete Ansteuerung für einen Sperrzustand den Steueranschluß desjenigen Halbleiterschalters in etwa mit dem Potential des zweiten Versorgungspotentialanschlusses zu beaufschlagen. Dieses Vorgehen hat zur Folge, daß die Miller-Kapazität des zu sperrenden Halbleiterschalters verkleinert wird. Durch das Verkleinern der Miller-Kapazität wird verhindert, daß am sperrenden Schalter durch das Wechseln des Potentials an seinem Sourceanschluß von der Betriebsspannung auf das Bezugspotential die Einsatzspannung überschritten wird und dieser einen Querstrom leitet.

Vorteilhafte Ausgestaltungen ergeben sich aus den Unteransprüchen.

Vorteilhafterweise ist vorgesehen, daß zumindest eine der jedem Halbleiterschalter zugeordneten Ansteuerungen eine Sperreinrichtung aufweist, die zwischen dem Steueranschluß und dem zweiten Versorgungspotentialanschluß vorgesehen ist. Hierdurch ist beispielsweise bei einer H-Brückenschaltung möglich, daß Pulsweitenmodulationssignal wahlweise an den High-Side- oder den Low-Side-Halbleiterschalter anzulegen. Die Sperreinrichtung weist dabei vorteilhafterweise einen steuerbaren Halbleiterschalter auf.

In einer weiteren vorteilhaften Ausgestaltung weist die Sperreinrichtung eine seriell mit der Laststrecke des Halbleiterschalters verschaltete Diode auf. Durch die Diode wird erzielt, daß der Sourceanschluß des sperrenden Halbleiterschalters in jedem Fall ein tieferes Potential als der Gateanschluß des zu sperrenden Halbleiterschalters aufweist.

In einer vorteilhaften Ausgestaltung ist die Sperreinrichtung zwischen dem Steueranschluß und dem Sourceanschluß des zu sperrenden Halbleiterschalters verschalten. Hierdurch wird erzielt, daß die Miller-Kapazität sowohl bei einem High-Side- als auch bei einem Low-Side-Halbleiterschalter verkleinert werden kann.

In einer weiteren vorteilhaften Ausgestaltung ist zwischen dem Haibleiterschalter der Sperreinrichtung und dem zweiten Versorgungspotentialanschluß ein Widerstand geschalten. Üblicherweise ist das Bezugspotential der Ansteuerschaltung und das im Lastpfad befindliche Bezugspotential nicht das Gleiche. Dies könnte zur Folge haben, daß bei Verschiebungen des Bezugspotentiales am Steueranschluß des zu sperrenden Halbleiterschalters ein gegenüber dem Sourceanschluß höheres Potential auftreten könnte. In diesem Falle würde der Halbleiterschalter leitend geschalten werden. Dieses Problem wird durch den Widerstand verringert. Dieser gewährleistet bei einer unerwünschten Massepotentialverschiebung, daß das sichere Sperren des High-Side- oder Low-Side-Halbleiterschalters erhalten bleibt.

In einer weiteren vorteilhaften Ausbildung ist ein weiterer Halbleiterschalter vorgesehen, der mit seiner Laststrecke zwischen dem ersten Versorgungspotentialanschluß und dem Verbindungspunkt des Halbleiterschalters mit der Diode der jeweiligen Sperreinrichtung verschalten ist und dessen Steueranschluß mit der jeweiligen Ansteuerung verbunden ist. Der weitere Halbleiterschalter dient dazu, das Potential des Sourceanschlusses des Halbleiterschalters der Sperreinrichtung auf ein hohes Bezugspotential bringen zu können, um zu gewährleisten, daß dieser in einen sperrenden Zustand übergehen kann. Hierdurch ist ein Einschalten des High-Side- bzw. Low-Side-Halbleiterschalters wiederum möglich. Das Vorsehen des weiteren Halbleiterschalters ermöglicht zudem schnellere Schaltvorgänge der Treiberanordnung.

In einer Weiterbildung der Erfindung ist dem Halbleiterschalter der Sperreinrichtung ein Halbleiterschalter parallel geschalten, dessen Gate- und Sourceanschluß mit einem mittels eines Ansteuersignals steuerbaren Schalter verbunden ist. Ferner ist der Diode der Sperreinrichtung ebenfalls ein Halbleiterschalter parallel geschalten. Durch diese Schaltelemente kann der pulsweitenmodulierte Halbleiterschalter der Halbbrücke auch mit sehr großen 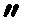 durty-cyclen" und unabhängig von der Frequenz betrieben werden, ohne daß der zu sperrende Halbleiterschalter der Halbbrücke leitend wird. Dies wird dadurch ermöglicht, daß der parallelgeschaltene Halbleiterschalter zu dem Halbleiterschalter der Sperreinrichtung sehr niederohmig ist, während der Halbleiterschalter der Sperreinrichtung in der Regel auf die Erfordernisse einer vorgegebenen 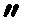 Slew-rate" ausgelegt ist. Somit ist eine Klemmung des Gateanschlusses des Halbleiterschalters der Halbbrücke unabhängig von der slew-rate des Halbleiterschalters der Sperreinrichtung möglich.

Vorzugsweise schaltet die Sperreinrichtung den zugeordneten Halbleiterschalter erst dann sperrend, bevor der andere Halbleiterschalter leitend geschalten wird. Dies ist insbesondere dann von Bedeutung, wenn sowohl der High-Side- als auch der Low-Side-Schalter einer Halbbrücke über eine Pulsweitenmodulation betrieben werden, um einen direkten Strompfad zwischen dem ersten und dem zweiten Versorgungspotentialanschluß zu verhindern.

In einer weiteren vorteilhaften Ausgestaltung sind eine erste, dem Low-Side-Halbleiterschalter zugeordnete Spannungsdetektionseinrichtung und eine zweite, dem High-Side-Halbleiterschalter zugeordnete Spannungsdetektionseinrichtung vorgesehen, die jeweils die Spannung am Steueranschluß des zugeordneten Halbleiterschalters erfassen und die jeweils mit der Ansteuerung des nicht zugeordneten Halbleiterschalters verbunden sind. Hierbei ermöglicht die erste Spannungsdetektionseinrichtung nach dem Sperren des Low-Side-Halbleiterschalters der Ansteuerung das Leitendschalten des High-Side-Halbleiterschalters. Andererseits ermöglicht die zweite Spannungsdetektionseinrichtung nach dem Sperren des High-Side-Halbleiterschalters der Ansteuerung das Leitendschalten des Low-Side-Halbleiterschalters.

Vorteilhafterweise weist die erste Spannungsdetektionseinrichtung einen Halbleiterschalter auf, dessen Steueranschluß mit dem Steueranschluß des Low-Side-Halbleiterschalters verbunden ist und dessen Laststrecke zwischen dem Steueranschluß des High-Side-Halbleiterschalters und dem zweiten Versorgungspotentialanschluß liegt. Somit kann mittels eines einzigen Bauelementes der Zustand des Low-Side-Halbleiterschalters detektiert werden.

In einer weiteren vorteilhaften Ausgestaltung weist die zweite Spannungsdetektionseinrichtung einen ersten Spannungsteiler auf, dessen Mittelabgriff einem zweiten Spannungsteiler zugeführt wird, wobei der Mittelabgriff des zweiten Spannungsteilers mit der dem Low-Side-Halbleiterschalter zugeordneten Treibereinrichtung verbunden ist und diese steuert. Hierdurch wird einerseits erzielt, daß der Zustand des High-Side-Halbleiterschalters detektiert wird und gleichzeitig der Treiberanordnung des Low-Side-Halbleiterschalters erst dann ein Leitenschalten des Low-Side-Halbleiterschalters ermöglicht wird, wenn der High-Side-Halbleiterschalter im gesperrten Zustand ist.

Die Erfindung wird durch die nachfolgenden Figuren näher erläutert. Es zeigen:
- Figur 1: eine bereits beschriebene prinzipielle Steuereinrichtung für einen High-Side-Halbleiterschalter,
- Figur 2: eine aus dem Stand der Technik bekannte H-Brückenschaltung,
- Figur 3: den Verlauf der Miller-Kapazität in Abhängigkeit der Gate-Source-Spannung eines Halbleiterschalters,
- Figur 4: ein erstes Ausführungsbeispiel einer Steuereinrichtung für einen High-Side-Halbleiterschalter gemäß der Erfindung,
- Figur 5: ein zweites Ausführungsbeispiel einer Ansteuerung für einen Low-Side-Halbleiterschalter und
- Figur 6: ein weiteres Ausführungsbeispiel einer erfindungsgemäßen Treiberschaltung für den Einsatz in einer Drehstrom-Brückenschaltung.

Figur 3 zeigt den Verlauf der Miller-Kapazität in Abhängigkeit von der Gate-Drain-Spannung eines Halbleiterschalters, insbesondere eines MOSFETs. Die gleiche Abhängigkeit ergibt sich, wenn statt der Gate-Drain-Spannung die Gate-Source-Spannung aufgetragen wird. Die Miller-Kapazität ist dann am Größten, wenn die Spannungsdifferenz zwischen Gate und Drain "0" ist. Mit AP1 ist ein Arbeitspunkt gekennzeichnet, den die Miller-Kapazität bei einer Schaltungsanordnung gemäß dem Stand der Technik annimmt. Soll beim Stand der Technik ein Halbleiterschalter sperrend geschalten sein, so wird seine Gate-Source-Spannung annähernd zu "0" gemacht. Befindet sich der Lastausgang aus Figur 1 beispielsweise auf dem Versorgungspotential V_{bb} so liegt das Gate ebenfalls annähernd auf V_{bb}. Wird durch einen Schaltvorgang des Low-Side-Halbleiterschalters der Halbbrücke der Lastausgang auf das Bezugspotential gebracht, so muß das Potential am Gate des High-Side-Schalters ebenfalls dem Potential des Lastausgangs folgen. Der Arbeitspunkt AP1 müßte folglich auf der in Figur 3 eingezeichneten Kennlinie weiter nach rechts wandern. Dies bedeutet, die Miller-Kapazität müßte sehr schnell umgeladen werden. In der Praxis ist dieser Umladevorgang jedoch nicht schnell genug, als daß die Gate-Source-Spannung des High-Side-Schalters die Einsatzspannung nicht überschreiten würde. Dies hat das kurzzeitige Leitendwerden des High-Side-Halbleiterschalters zur Folge.

Wird der Low-Side-Halbleiterschalter der Halbbrücke mit sehr hoher Frequenz leitend und sperrend geschaltet, so tritt das kurzzeitige Einschalten des Halbleiterschalters entsprechend der Ansteuerfrequenz auf. Die im Halbleiterschalter umgesetzte Energie ist so hoch, daß der High-Side-Halbleiterschalter thermisch zerstört werden könnte. Liegt die Kapazität eines gesperrten Halbleiterschalters über der in Figur 3 parallel zur x-Achse verlaufenden Gerade, so besteht die potentielle Gefahr eines Querstromes. Je kleiner jedoch die Miller-Kapazität bei einem Potentialwechsel am Lastausgang ist, desto geringer wird die Gefahr eines Querstromes.

Gemäß der Erfindung wird die Potentialdifferenz zwischen Gate und Source nicht zu 0 gemacht. Das Gate des gesperrten Halbleiterschalters wird vielmehr annähernd auf das zweite Versorgungspotential gebracht. Durch das geringe Potential am Gate des zu sperrenden Halbleiterschalters fällt über der Miller-Kapazität eine größere Spannungsdifferenz ab. Dies ist in Figur 3 durch den Arbeitspunkt AP2 gekennzeichnet. Diese Vorgehensweise hat den Vorteil, daß für das Umladen der Miller-Kapazität wesentlich weniger Zeit benötigt wird, d. h. der Arbeitspunkt AP2 kann entlang der Kennlinie sehr viel schneller nach rechts wandern. Weiterhin ist durch die 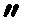 Vorspannung" des Gates gegenüber dem Sourceanschluß sichergestellt, daß die Einsatzspannung des zu sperrenden Halbleiterschalters nicht überschritten werden kann. Physikalisch bedeutet dies, daß bei einer genügend großen gegenüber dem Sourceanschluß negativen Gate-Spannung eine Inversionsschicht unter dem Gate gebildet wird, welche das Gate vom Substrat abschirmt und auf diese Weise die Wirkung der Miller-Kapazität verringert. Wesentlich ist es also, über der Miller-Kapazität eine Spannung aufzubauen, indem das Gate des zu sperrenden Halbleiterschalters beispielsweise auf Bezugspotential gebracht wird.

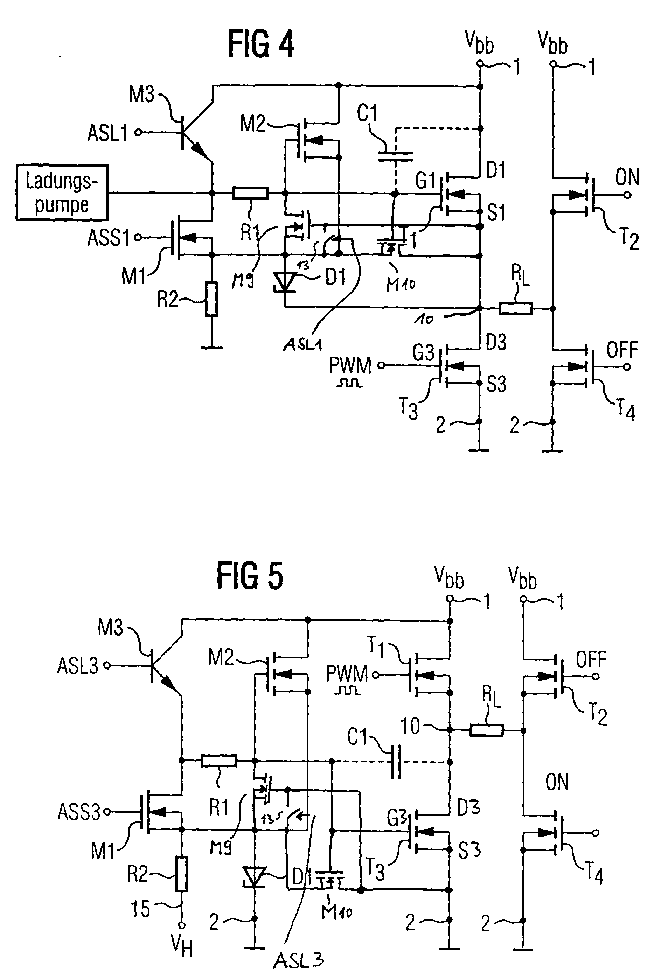

In Figur 4 ist ein erstes Ausführungsbeispiel für eine Ansteuerung eines High-Side-Halbleiterschalters dargestellt, bei dem ein Querstrom vermieden werden kann. Figur 4 zeigt eine Lösungsmöglichkeit für die bereits in Figur 2 beschriebene H-Brückenschaltung. Die Ansteuerung zum Leitendschalten des High-Side-Halbleiterschalters T1, im vorliegenden Beispiel ein MOSFET, wird mittels einer Ladungspumpe LP und eines Bipolartransistors M3 vorgenommen. Die Ladungspumpe LP ist über einen Widerstand R1 mit dem Gate des MOSFETs T1 verbunden. Der Bipolartransistor M3 ist zwischen dem ersten Versorgungspotentialanschluß 1 und dem Verbindungspunkt der Ladungspumpe LP mit dem Widerstand R1 vorgesehen. An die Basis des Bipolartransistors M3 kann über einen Steuereingang ASL1 ein Steuersignal angelegt werden.

Der High-Side-Halbleiterschalter T1 ist drainseitig mit dem ersten Versorgungspotentialanschluß 1 und sourceseitig mit einem Lastausgang 10 verbunden. Der Lastausgang 10 ist einerseits mit einer Last RL und andererseits mit dem Drainanschluß eines pulsweitenmodulierten Low-Side-Halbleiterschalters T3 (z. B. ein MOSFET) verbunden. Sourceseitig ist der Halbleiterschalter T3 mit dem zweiten Versorgungspotentialanschluß 2, an welchem beispielsweise das Bezugspotential anliegt, verbunden.

Zum Sperrendschalten des High-Side-Halbleiterschalters T1 ist ein Halbleiterschalter M1 vorgesehen. Drainseitig ist der Halbleiterschalter M1 mit dem Verbindungspunkt zwischen der Ladungspumpe und dem Widerstand R1 verbunden. Sourceseitig ist der Halbleiterschalter M1 mit dem Anodenanschluß einer Zenerdiode D1 verbunden. Die Kathode der Zenerdiode D1 ist mit dem Lastausgang 10 verbunden. Weiterhin ist ein Widerstand R2 vorgesehen, der mit seinem ersten Anschluß mit dem Sourceanschluß des Halbleiterschalters M1 verbunden ist. Der zweite Anschluß des Widerstandes R2 ist mit dem zweiten Versorgungspotentialanschluß 2 verbunden. Der Widerstand R2 dient dazu, das Gate des High-Side-Halbleiterschalters T1 über die Entladestrecke des Widerstandes R1 und die Laststrecke des Halbleiterschalters M1 auf das am zweiten Versorgungspotentialanschluß 2 anliegende Potential zu klemmen. Die Diode D1 läßt bei gesperrtem Halbleiterschalter T1 an seinem Sourceanschluß S1 höhere Spannungen als am Gate G1 zu.

Es ist ein weiterer Halbleiterschalter M2 vorgesehen, der drainseitig mit dem ersten Versorgungspotentialanschluß 1 in Verbindung steht. Sein Sourceanschluß ist mit dem Sourceanschluß des Halbleiterschalters M1 verbunden. Der weitere Halbleiterschalter M2 ist vom gleichen Typ wie der High-Side-Halbleiterschalter T1. Das Gate des weiteren Halbleiterschalters M2 ist mit dem Gate des High-Side-Halbleiterschalters T1 verbunden.

Der Halbleiterschalter M1 ist üblicherweise so dimensioniert, daß er keine störende elektromagnetische Abstrahlung verursacht. Dies bedeutet, seine 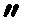 slew-rate", das heißt die maximale Stromanstiegsgeschwindigkeit, ist begrenzt. Diese Dimensionierung könnte bei ungünstigen 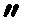 duty-cyclen" des pulsweiten modulierten Low-side-Halbleiterschalters T3 trotz der erfindungsgemäßen Klemmung des Gates des Halbleiterschalters T1 dazu führen, daß dieser kurzzeitig einen Querstrom leitet. Dies wird durch einen weiteren Halbleiterschalter M9 verhindert, der sourceseitig mit dem Sourceanschluß des Halbleiterschalters M1 und drainseitig mit dem Gate des Halbleiterschalters T1 verbunden ist. Der Gateanschluß des Halbleiterschalters M9 ist mit dem Sourceanschluß S1 des Halbleiterschalters T1 verbunden. Ferner ist ein weiterer Halbleiterschalter M10 vorgesehen, der mit seiner Laststrecke parallel zu der Diode D1 gelegen ist. Sourceseitig steht er dabei mit dem Sourceanschluß des Halbleiterschalters M1 in Verbindung. Der Gateanschluß des Halbleiterschalters M10 ist mit dem Gateanschluß des Halbleiterschalters T1 verbunden. Zwischem dem Gate- und Sourceanschluß des Halbleiterschalters M9 ist ein Schalter 13 vorgesehen, der mit dem Ansteuersignal ASL1 beaufschlagt werden kann.

Soll der High-side-Halbleiterschalter T1 von einem leitenden in den sperrenden Zustand gebracht werden, so wird sein Gate über den Halbleiterschalter M1 entladen. Während des Entladevorganges befindet sich der Halbleiter M9 im gesperrten Zustand, während der Halbleiterschalter M10 leitend ist. Erst wenn die Gatespannung des Halbleiterschalters T1 kleiner als seine Sourcespannung geworden ist, wird der Halbleiterschalter M10 sperrend, so daß der Halbleiterschalter M9 in den leitenden Zustand gelangen kann. Im sperrenden Zustand des Halbleiterschalters T1 der Halbbrücke befindet sich der Halbleiterschalter M9 im leitenden Zustand, wobei dieser im Gegenssatz zum Halbleiterschalter M1 sehr niederohmig realisiert ist. Der Halbleiterschalter M10 befindet sich dann im sperrenden Zustand, der Schalter 13 ist geöffnet.

Wechselt der Ausgang 10 aufgrund des pulsweitenmodulierten Halbleiterschalters T3 vom Potential des zweiten Versorgungspotentialanschlusses 2 auf das Versorgungspotential V_{bb}, so wird das Gate G1 kapazitiv über das Potential am Verbindungspunkt zwischen M1 und R2 gehoben. Während dieser Verbindungspunkt über den Widerstand R2 an den zweiten Versorgungspotentialanschluß 2 geklemmt ist, wird die Klemmung des Gates G1 durch den Halbleiterschalter M1 bestimmt. Diese ist von der Slew-Rate des Halbleiterschalters M1 abhängig. Befindet sich der Ausgang 10 nur sehr kurze Zeit auf dem Versorgungspotential V_{bb} und wird dann wieder mit dem Bezugspotential am zweiten Versorgungspotentialanschluß 2 verbunden, ist die Klemmung des Gates G1 über den Halbleiterschalter M1 nicht mehr ausreichend, um das Gate G1 schnell genug zu entladen. Für kurze Zeit kann deshalb die Einsatzspannung des Halbleiterschalters T1 überschritten werden, so daß dieser einschaltet. Durch die oben beschrieben Schaltungsanordnung mit den Halbleiterschaltern M9 und M10 wird dieser unerwünschte Zustand verhindert.

Möchte man den High-Side-Halbleiterschalter in einen leitenden Zustand bringen, so wird über das entsprechende Ansteuersignal an den Steuereingängen ASL1 der Bipolartransistor M3 leitend geschalten, während durch ein entsprechendes Ansteuersignal ASS1 der Halbleiterschalter M1 sperrend geschaltet wird. Ist der Bipolartransistor M3 im leitenden Zustand, so wird über den Widerstand R1 und die Ladungspumpe LP das Gate des Halbleiterschalters M2 aufgeladen, so daß dieser zu leiten beginnt. In diesem Fall stellt sich am Sourceanschluß des Halbleiterschalters M1 das Bezugspotential V_{bb} ein. Zusammen mit dem entsprechenden Ansteuersignal ASS1 wird der Halbleiterschalter M1 sicher in den sperrenden Zustand gebracht, so daß die von der Ladungspumpe im Zusammenspiel mit dem Bipolartransistor M3 erzeugte Ladung auf das Gate des High-Side-Halbleiterschalters T1 fließen kann und diesen leitend schalten kann.

Durch das Ansteuersignal an dem Steuereingang ASL1 wird auch der Schalter 13 leitend geschalten, so daß der Halbleiterschalter M9 sperrend wird. Hierdurch kann der von der Ladungspumpe in Verbindung mit dem Bipolartransistor M3 erzeugte Strom auf das Gate G1 des Halbleiterschalters T1 fließen. Eine Einschaltverzögerung wird dann gering gehalten.

Der Vorteil der gezeigten Schaltungsanordnung besteht darin, daß das Gate des High-Side-Halbleiterschalters T1 bei einem Potentialwechsel am Lastausgang 10 von dem Versorgungspotential V_{bb} auf das Bezugspotential der Spannung am Sourceanschluß nicht folgen muß. Die Wirkung der Miller-Kapazität, die das Potential des Gateanschlusses aufgrund der kapazitiven Kopplung halten möchte, wie dies beim Stand der Technik der Fall ist, ist somit verhindert. Ein Querstrom ist ausgeschlossen.

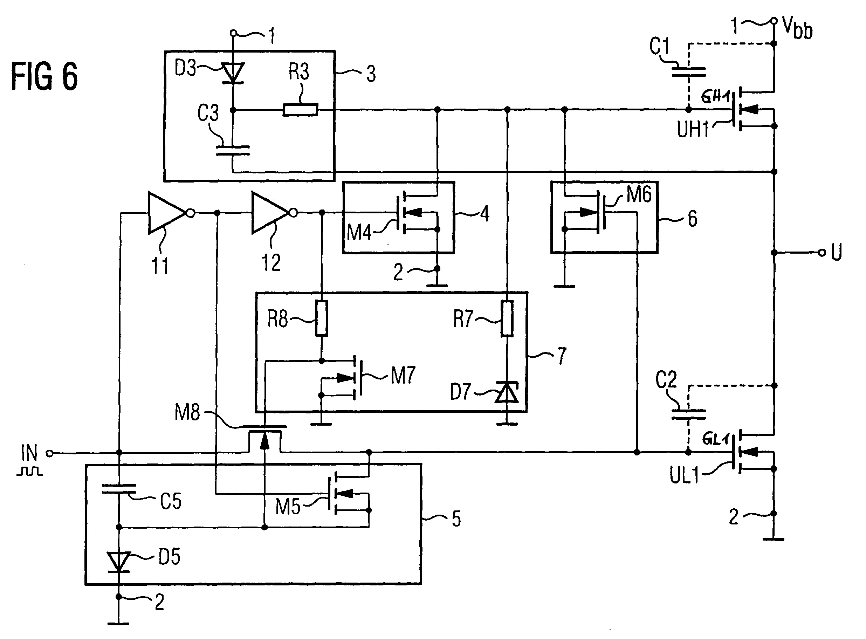

In Figur 5 ist ein Ausführungsbeispiel für eine Steuereinrichtung eines Low-Side-Halbleiterschalters dargestellt. In diesem Fall wird der High-Side-Halbleiterschalter T1 der Halbbrücke mit einem pulsweiten modulierten Signal beaufschlagt. Der Low-Side-Halbleiterschalter T4 der zweiten Halbbrücke ist permanent leitend geschalten, während der High-Side-Halbleiterschalter T2 der zweiten Halbbrücke im ausgeschalteten Zustand ist.

Die Ansteuerschaltung für einen Low-Side-Halbleiterschalter ist prinzipiell identisch aufgebaut wie für einen High-Side-Halbleiterschalter. Ein Unterschied besteht darin, daß keine Ladungspumpe zur Ansteuerung des Low-Side-Halbleiterschalters notwendig ist. Der zweite Unterschied besteht darin, daß der Widerstand R2 anstatt mit dem zweiten Versorgungspotentialanschluß 2 an einem Anschluß für eine Hilfsspannung VH liegt.

Die Hilfsspannung VH ist kleiner als das Potential am zweiten Versorgungspotentialanschluß 2 zu wählen.

Der kritische Schaltzustand bei einem Low-Side-Halbleiterschalter besteht in einem Ansteigen des Potentials am Lastausgang 10 vom Bezugspotential des zweiten Versorgungspotentialanschluß 2 auf die Versorgungsspannung V_{bb}. In diesem Fall kann es aufgrund der kapazitiven Kopplung zwischen dem Drain und dem Gate des Low-Side-Halbleiterschalters T3 zu einem kurzzeitigen Anstieg der Gatespannung kommen, so daß die Einsatzspannung des MOSFETs T3 überschritten werden könnte. Die Miller-Kapazität wird deshalb dadurch verringert, daß das Gate des Low-Side-Halbleiterschalters T3 mittels der Hilfsspannung VH auf ein negatives Potential relativ zum zweiten Versorgungspotnetialanschluß 2 gebracht ist. In diesem Fall befindet sich der Arbeitspunkt wiederum unter der kritischen Linie, die parallel zur x-Achse aus Figur 3 verläuft.

Figur 6 zeigt ein weiteres Ausführungsbeispiel für eine Treiberschaltung einer Halbbrücke, welche vorteilhafterweise bei einer Drehstrom-Brückenschaltung zur Anwendung kommt. Kennzeichnend dafür ist, daß sowohl der High-Side- als auch der Low-Side-Halbleiterschalter entsprechend einer an einem Steuereingang IN angelegten Frequenz leitend und sperrend geschalten werden. Die Halbbrücke gemäß des dritten Ausführungsbeispieles besteht aus zwei seriell miteinander verschalteten Halbleiterschaltern UH1, UL1. Der High-Side-Halbleiterschalter UH1 ist drainseitig mit dem ersten Versorgungspotentialanschluß 1, sourceseitig mit einem Lastausgang U und dem Drainanschluß des Low-Side-Halbleiterschalters UL1 verbunden. Sourceseitig ist der Low-Side-Halbleiterschalter UL1 mit dem zweiten Versorgungspotentialanschluß 2 verbunden, der auf Bezugspotential liegt.

Die Treiberschaltung weist eine erste Treibereinrichtung 3 auf, die dem High-Side-Halbleiterschalter UH1 zugeordnet ist.

Sie ist zwischen dem ersten Versorgungspotentialanschluß 1 und dem Gate- bzw. Sourceanschluß des MOSFETs UH1 verschalten. Sie ist in Form einer Bootstrap-Schaltung ausgelegt, d. h. sie besteht aus einer Diode D3, einem Ladungsspeicher C3 und einem Widerstand R3. Der Anodenanschluß der Diode D3 ist mit dem ersten Versorgungspotentialanschluß 1 verbunden. Kathodenseitig ist die Diode D3 einerseits mit einem ersten Anschluß des Widerstandes R3 und andererseits mit einem ersten Anschluß des Widerstandes R3 und andererseits mit einem ersten Anschluß des Ladungsspeichers C3 verbunden. Der andere Anschluß des Widerstandes R3 ist mit dem Gateanschluß des MOSFETs UH1 verbunden. Der zweite Anschluß des Ladungsspeichers C3 ist mit dem Sourceanschluß des MOSFETs UH1 verbunden.

Die zweite Treibereinrichtung 8, die dem Low-Side-Halbleiterschalter UL zugeordnet ist, besteht aus einem n-Kanal-Depletion-Halbleiterschalter M8. Die Lastanschlüsse des MOSFETs M8 sind einerseits mit einem Steuereingang IN verbunden, an dem ein pulsweitenmoduliertes Signal anliegt, andererseits mit dem Gate des als MOSFET ausgeführten Low-Side-Halbleiterschalters UL1.

Die Treiberschaltung weist ferner eine erste und eine zweite Spannungsdetektionseinrichtung 6, 7 auf. Die erste Spannungsdetektionseinrichtung 6 ist dabei dem Low-Side-Halbleiterschalter UL1 zugeordnet und besteht aus einem n-Kanal-Depletion-MOSFET M6. Der Drainanschluß des Halbleiterschalters M6 ist mit dem Gate des High-Side-Halbleiterschalters UH1 verbunden. Sourceseitig ist der Halbleiterschalter M6 mit dem zweiten Versorgungspotentialanschluß 2 verbunden. Das Gate des Halbleiterschalters M6 ist mit dem Gate des Low-Side-Halbleiterschalters UL1 verbunden. Die Halbleiterschalter M6 und UL1 sind dabei vom entgegengesetzten Kanaltyp.

Die zweite Spannungsdetektionseinrichtung 7 besteht aus zwei Spannungsteilern R7, D7 sowie R8, M7. Der erste Spannungsteiler weist einen Widerstand R7 und eine Diode D7 auf. Dabei ist die vorteilhafterweise als Zenerdiode ausgeführte Diode D7 mit ihrem Anodenanschluß mit dem zweiten Versorgungspotentialanschluß 2 verbunden. Anodenseitig ist sie mit einem Anschluß des Widerstandes R7 verbunden. Der Widerstand R7 steht ferner mit dem Gate des High-Side-Halbleiterschalters UH1 in Verbindung. Der Mittelabgriff des ersten Spannungsteilers R7, D7 ist mit dem Steueranschluß eines als MOSFET ausgeführten Halbleiterschalters M7 verbunden. Dessen Sourceanschluß ist mit dem zweiten Versorgungspotentialanschluß 2 verbunden. Der Drainanschluß steht mit einem Widerstand R8 in Verbindung, der mit seinem anderen Anschluß mit dem Ausgang eines Inverters 12 in Verbindung steht. Der Mittelabgriff des zweiten Spannungsteilers R8, M7 ist mit dem Steueranschluß der Treibereinrichtung 8 (Gate des MOSFETs M8) verbunden.

Der Steuereingang IN steht ferner mit einem Eingang eines Inverters 11 in Verbindung, dessen Ausgang einerseits mit dem Eingang des zweiten Inverters 12 und andererseits mit einer dem Low-Side-Halbleiterschalter zugeordneten Sperreinrichtung 5 verbunden ist. Der Ausgang des ersten Inverters 11 ist ferner mit dem Gate eines MOSFETs M5 verbunden. Dies dem Low-Side-Halbleiterschalter UL1 zugeordnete Sperreinrichtung 5 weist den als MOSFET ausgebildeten Halbleiterschalter M5, einen Ladungsspeicher C5 sowie eine Diode D5 auf. Der erste Anschluß des Ladungsspeichers C5 ist mit dem Eingang IN verbunden. Der andere Anschluß des Ladungsspeichers C5 steht einerseits mit dem Anodenanschluß der Diode D5, andererseits mit dem Sourceanschluß des MOSFETs M5 in Verbindung. Ferner besteht vom zweiten Anschluß des Ladungsspeichers C5 eine Verbindung zum Substrat des MOSFETs M8. Kathodenseitig ist die Diode D5 mit dem zweiten Versorgungspotentialanschluß 2 verbunden. Der Drainanschluß des MOSFETs M5 ist mit dem Gate des Low-Side-Halbleiterschalters UL1 verbunden.

Die dem High-Side-Halbleiterschalter UH1 zugeordnete Sperreinrichtung 4 besteht aus einem einzelnen, als MOSFET ausgebildeten Halbleiterschalter M4. Drainseitig ist dieser mit dem Gate des High-Side-Halbleiterschalters UH1 verbunden, während dieser sourceseitig mit dem zweiten Versorgungspotentialanschluß 2 in Verbindung steht.

Im folgenden wird die Funktionsweise der Treiberschaltung kurz erläutert:

Es wird von einem Zustand ausgegangen, in dem am Steuereingang IN ein logisches L anliegt. Dies hat zur Folge, daß der High-Side-Halbleiterschalter UH1 im leitenden Zustand ist, während der Low-Side-Halbleiterschalter UL1 gesperrt ist. Am Lastausgang U liegt deshalb die Betriebsspannung V_{bb} an. Wechselt das am Eingang IN anliegende Signal von einem logischen L auf ein logisches H, so wird der MOSFET M4 über die zwei Inverter 11, 12 leitend geschalten. Der High-Side-Halbleiterschalter UH1 beginnt zu sperren. Die am Gate des MOSFETs UH1 anliegende Spannung wird über den Spannungsteiler R7, D7 detektiert. Über den zweiten Spannungsteiler R8, M7 wird der MOSFET M8 leitend gesteuert, um den Low-Side-Halbleiterschalter UL1 leitend zu schalten. Um das Leitendschalten des MOSFETs UL1 zu ermöglichen, muß der MOSFET M7 ausgeschaltet sein. Das Ausschalten des MOSFETs M7 erfolgt erst dann, wenn die Spannung am Gate des High-Side-Halbleiterschalters UH1 soweit abgesunken ist, daß die Miller-Kapazität des MOSFETs UH1 bereits so klein ist, so daß durch das Einschalten des Low-Side-Halbleiterschalters UL1 kein Querstrom mehr durch den MOSFET UH1 erzeugt werden kann. Solange der Low-Side-Halbleiterschalter UL1 im leitenden Zustand ist, ist der MOSFET M5 über den Ausgang des ersten Inverters 11 sperrend geschalten. Der MOSFET M6 befindet sich während des Leitens des Low-Side-Halbleiterschalters UL1 im nicht leitenden Zustand, d. h. der Depletiontransistor M6 weist eine positive Gate-Source-Spannung auf.

Wechselt das Signal am Steuereingang IN wiederum auf ein logisches L, so wird über den Inverter 11 der MOSFET M5 leitend geschalten. Ebenso wird an der Anode von D5 kurzzeitig eine negative Spannung über C5 generiert, so daß das Gate des Low-Side-Halbleiterschalters UL1 auf ein negatives Potential gebracht wird, um die Millerkapazität C2 von UL1 zu verkleinern. Sobald am Steuereingang IN ein logisches L anliegt, geht der MOSFET M4 in den sperrenden Zustand über. Über die Spannungsteiler R7, D7 und R8, M7 wird das Gate des MOSFET M8 auf Versorgungspotential 2 gebracht. Sein Substrat ist auf negatives Potential, so daß M8 in dem sperrenden Zustand gebracht ist. Ein Nachfließen von Ladung über den MOSFET M8, der im wesentlichen einen steuerbaren Widerstand darstellt, ist somit nicht mehr möglich. Dadurch, daß der MOSFET M4 im sperrenden Zustand ist, wäre ein Nachfließen von Ladung jedoch auf das Gate des High-Side-Halbleiterschalters UH1 möglich. Dies wird jedoch durch den MOSFET M6 unterbunden, solange die Spannung am Gate des Low-Side-Halbleiterschalters UL1 nicht einen Wert erreicht hat, der eine geringe Miller-Kapazität zur Folge hat. Erst sobald die Miller-Kapazität klein genug ist, so daß ein Querstrom durch den Low-Side-Halbleiterschalter UL1 beim Einschalten des High-Side-Halbleiterschalters UH1 unterbunden ist, wird der Halbleiterschalter M6 gesperrt. Erst jetzt kann das Gate des High-Side-Halbleiterschalters UH1 aufgeladen werden, um somit den High-Side-Halbleiterschalter UH1 in den leitenden Zustand zu bringen.

Mittels der erfindungsgemäßen Treiberschaltung ist es somit auf einfache Weise möglich, Querströme in Halbbrücken zu verhindern. Dabei ist es unerheblich, ob nur einer der beiden Halbleiterschalter mittels eines pulsweiten modulierten Signales leitend und sperrend geschalten wird oder aber ob beide Halbleiterschalter im gegenseitigen Wechsel leitend und sperrend geschalten werden.

### Bezugszeichenliste

- T1: High-Side-Halbleiterschalter
- T2: High-Side-Halbleiterschalter
- UH1: High-Side-Halbleiterschalter
- T3: Low-Side-Halbleiterschalter
- T4: Low-Side-Halbleiterschalter
- UL1: Low-Side-Halbleiterschalter
- M2: n-Kanal-Enhancement-MOSFET
- M1: n-Kanal-Depletion-MOSFET
- M3: Bipolartransistor
- R_{L}: Last
- R1: Widerstand
- R2: Widerstandc
- D1: Zenerdiode
- LP: Ladungspumpe
- G1: Steueranschluß (High-Side-)
- G3: Steueranschluß (High-Side-)
- GH1: Steueranschluß (High-Side-)
- GL1: Steueranschluß (High-Side-)
- ASL1: Steuereingang
- ASS1: Steuereingang
- ASL3: Steuereingang
- ASS3: Steuereingang
- IN: Steuereingang
- 1: erster Versorgungspotentialanschluß (V_{bb})
- 2: zweiter Versorgungspotentialanschluß (Bezugspotential)
- 15: dritter Versorgungspotentialanschluß (Bezugspotential < Hilfsspannung < V_{bb})
- 10: Verbindungspunkt (Ausgang)
- C1: Miller-Kapazität
- U: Verbindungspunkt Ausgang für 1. Phase)
- 3: Treiberschaltung
- R3: Widerstand
- D3: Diode
- C3: Ladungsspeicher
- 4: Sperreinrichtung
- M4: n-Kanal-Enhancement-Halbleiterschalter
- 5: Sperreinrichtung
- M5: n-Kanal-Enhancement-Halbleiterschalter
- C5: Ladungsspeicher
- D5: Diode
- 6: Spannungsdetektionseinrichtung (Low-Side)
- M6: n-Kanal-Depletion-Halbleiterschalter
- 7: Spannungsdetektionseinrichtung (High-Side)
- R7: Widerstand
- D7: Diode
- M7: n-Kanal-Enhancement-Halbleiterschalter
- R8: Widerstand
- 8: Treibereinrichtung
- M8: n-Kanal-Depletion-Halbleiterschalter
- 11: Inverter
- 12: Inverter
- 13: Schalter
- M9: n-Kanal-Enhancement-Halbleiterschalter
- M10: n-Kanal-Enhancement-Halbleiterschalter

## Patentansprüche

1. Treiberschaltung zum Ansteuern einer Halbbrücke (T1, T3; T2, T4; UH1, UL1) bestehend aus einem High-Side-(T1, T2, UH1) und einem Low-Side-Halbleiterschalter (T3, T4, UL1), die seriell zwischen einem ersten und einem zweiten Versorgungspotentialanschluß (1, 2) verschalten sind, wobei jedem Halbleiterschalter eine Ansteuerung (3, 4; 5, 8) zugeordnet ist, die nach Maßgabe eines Ansteuersignals (ASL1, ASL3; ASS1, ASS3; IN) den jeweiligen Halbleiterschalter leitend oder sperrend schaltet und wobei eine Last (RL) zwischen dem High-Side-(T1, T2, UH1) und dem Low-Side-Halbleiterschalter (T3, T4, UL1) anschließbar ist
**dadurch gekennzeichnet,**
daß die einem Halbleiterschalter (T1, T3; T2, T4; UH1, UL1) zugeordnete Ansteuerung (3, 4; 5, 8) für einen Sperrzustand den Steueranschluß des Halbleiterschalters (T1, T3; T2, T4; UH1, UL1) in etwa mit dem Potential des zweiten Versorgungspotentialsanschlusses (2) beaufschlagt.

2. Treiberschaltung nach Anspruch 1,
**dadurch gekennzeichnet,**
daß zumindest eine der jedem Halbleiterschalter zugeordneten Ansteuerungen (3, 4; 5, 8) eine Sperreinrichtung (4, 5) aufweist, die zwischen dem Steueranschluß (G1, G3, GH1, GL1) und dem zweiten Versorgungspotentialanschluß (2) vorgesehen ist.

3. Treiberschaltung nach Anspruch 2,
**dadurch gekennzeichnet,**
daß die Sperreinrichtung (4, 5) einen steuerbaren Halbleiterschalter (M1, M4, M5) aufweist.

4. Treiberschaltung nach Anspruch 3,
**dadurch gekennzeichnet,**
daß die Sperreinrichtung (4, 5) eine seriell mit der Laststrecke des Halbleiterschalters (M1, M4, M5) verschaltete Diode (D1) aufweist.

5. Treiberschaltung nach Anspruch 4,
**dadurch gekennzeichnet,**
daß die Sperreinrichtung (4, 5) zwischen dem Steueranschluß (G1) und dem Sourceanschluß (S1) des High-Side-Halbleiterschalters (T1, T2, UH1) verschalten ist.

6. Treiberschaltung nach einem der Ansprüche 3 bis 5,
**dadurch gekennzeichnet,**
daß zwischen dem Halbleiterschalter (M1, M4, M5) und dem zweiten Versorgungspotentialanschluß ein Widerstand (R2) geschalten ist.

7. Treiberschaltung nach einem der Ansprüche 3 bis 6,
**dadurch gekennzeichnet,**
daß die Sperreinrichtung (5) des Low-Side-Halbleiterschalters (T3, T4, UL1) mit einem dritten Versorgungspotentialanschluß (15) verbunden ist.

8. Treiberschaltung nach einem der Ansprüche 4 bis 7,
**dadurch gekennzeichnet,**
daß ein weiterer Halbleiterschalter (M2) vorgesehen ist, der mit seiner Laststrecke zwischen dem ersten Versorgungspotentialanschluß und dem Verbindungspunkt des Halbleiterschalters (M1) mit der Diode (D1) der jeweiligen Sperreinrichtung geschalten ist und dessen Steueranschluß mit der jeweiligen Ansteuerung verbunden ist.

9. Treiberschaltung nach einem der Ansprüche 4 bis 8,
**dadurch gekennzeichnet,**
daß dem Halbleiterschalter (M1, M4) der Sperreinrichtung ein Halbleiterschalter (M9) parallel geschaltet ist, dessen Gate- und Sourceanschluß mit einem mittels des Ansteuersignals steuerbaren Schalter (13) verbunden ist und daß der Diode der Sperreinrichtung ebenfalls ein Halbleiterschalter (M10) parallel geschalten ist.

10. Treiberschaltung nach einem der Ansprüche 1 bis 7,
**dadurch gekennzeichnet,**
daß die Sperreinrichtung (5, 8) den zugeordneten Halbleiterschalter sperrend schaltet, bevor der andere Halbleiterschalter leitend geschalten wird.

11. Treiberschaltung nach Anspruch 10,
**dadurch gekennzeichnet,**
daß eine erste, dem Low-Side-Halbleiterschalter (UL1) zugeordnete, Spannungsdetektionseinrichtung (6) und eine zweite, dem High-Side-Halbleiterschalter (UH1) zugeordnete Spannungsdetektionseinrichtung (7) vorgesehen sind, die jeweils die Spannung am Steueranschluß (GH1, GL1) des zugeordneten Halbleiterschalters (UL1, UH1) erfassen und die jeweils mit der Ansteuerung des nicht zugeordneten Halbleiterschalters verbunden sind, wobei die erste Spannungsdetektionseinrichtung (6) nach dem Sperren des Low-Side-Halbleiterschalters (UL1) der Ansteuerung (3) das Leitendschalten des High-Side-Halbleiterschalters ermöglicht und wobei die zweite Spannungsdetektionseinrichtung (7) nach dem Sperren des High-Side-Halbleiterschalters (UH1) der Ansteuerung (2) das Leitendschalten des Low-Side-Schalters ermöglicht.

12. Treiberschaltung nach Anspruch 10 oder 11,
**dadurch gekennzeichnet,**
daß die erste Spannungsdetektionseinrichtung (6) einen Halbleiterschalter (M6) aufweist, dessen Steueranschluß mit dem Steueranschluß (GL1) des Low-Side-Halbleiterschalters (UL1) verbunden ist und dessen Laststrecke zwischen dem Steueranschluß (GH1) des High-Side-Halbleiterschalters (UH1) und den zweiten Versorgungspotentialanschluß (2) liegt.

13. Treiberschaltung nach einem der Ansprüche 10 bis 12,
**dadurch gekennzeichnet,**
daß die zweite Spannungsdetektionseinrichtung (7) einen ersten Spannungsteiler (R7, D7) aufweist, dessen Mittelabgriff einem zweiten Spannungsteiler (M7, R8) zugeführt wird, wobei der Mittelabgriff des zweiten Spannungsteilers (M7, R8) mit der dem Low-Side-Halbleiterschalters (UL1) zugeordneten Treibereinrichtung verbunden ist und diese steuert.
